Europäisches Patentamt

European Patent Office

Office européen des brevets

(11) Veröffentlichungsnummer: **0 245 695**
**A1**

(12) **EUROPÄISCHE PATENTANMELDUNG**

(21) Anmeldenummer: **87106170.1**

(22) Anmeldetag: **28.04.87**

(51) Int. Cl.4: **C04B 41/80** , **C04B 41/88** ,
**C23C 14/02**

(30) Priorität: **15.05.86 DE 3616325**

(43) Veröffentlichungstag der Anmeldung:
**19.11.87 Patentblatt 87/47**

(84) Benannte Vertragsstaaten:
**AT CH DE FR GB IT LI SE**

(71) Anmelder: **Nukem GmbH**
**Rodenbacher Chaussee 6 Postfach 11 00 80**
**D-6450 Hanau 11(DE)**

Anmelder: **Kernforschungsanlage Jülich**
**Gesellschaft mit beschränkter Haftung**
**Stetternischer Forst**
**D-5170 Jülich(DE)**

(72) Erfinder: **Hackstein, Karl-Gerhard, Dr.**
**Röntgenstrasse 20**
**D-6450 Hanau 1(DE)**
Erfinder: **Hrovat, Milan, Dr.**
**Meisenweg 7**
**D-6458 Rodenbach(DE)**
Erfinder: **Stritzker, Bernd, Dr.**
**Auf der Lache 8**
**D-5172 Linnich(DE)**

(74) Vertreter: **Nowak, Gerhard**
**DEGUSSA AG Fachbereich Patente**
**Rodenbacher Chaussee Postfach 1345**
**D-6450 Hanau 1(DE)**

(54) **Verfahren zum Metallisieren keramischer Körper.**

(57) Zur Erhöhung der Haftfestigkeit von aufgedampften Metallschichten auf karbidische und nitridische keramische Körper werden die zu metallisierenden Oberflächen vor der Metallabscheidung einer Ionenstrahlung mit Energien $\geq$ 10 keV und Dosen von $10^{16}$ bis $10^{18}$ Teilchen/cm² ausgesetzt.

EP 0 245 695 A1

## Verfahren zum Metallisieren keramischer Körper

Die Erfindung betrifft ein Verfahren zur Vorbehandlung karbidischer und nitridischer keramischer Körper, insbesondere von Siliziumkarbid, Siliziumnitrid und Aluminiumnitrid, deren Oberflächen anschließend mittels physikalischer Methoden metallisiert werden.

Das Aufdampfen von Metallen und die Kathodenzerstäubung sind Methoden zur Metallisierung von keramischen Unterlagen, die schon seit langem technisch angewendet werden. Die Haftfestigkeit der abgeschiedenen Schicht ist dabei stark abhängig von der Vorbehandlung der Unterlagen.

Bekannt ist die Reinigung der zu metallisierenden keramischen Oberflächen mit chemischen Lösungsmitteln, um beispielsweise Fette zu entfernen. Außerdem setzt man die Oberflächen vor der Bedampfung meist noch einer Glimmentladung von 3 bis 10 kV im Vakuum aus, um auch noch adsorbierte Dämpfe zu entfernen, die die Haftfestigkeit der Schichten beeinträchtigen.

Diese Vorbehandlung führt bei oxidischen Keramiken zu guten Haftfestigkeiten. Bei nitridischen und karbidischen keramischen Stoffen, wie Siliziumkarbid, Siliziumnitrid und Aluminiumnitrid, erreicht man mit diesen Vorbehandlungsmethoden keine optimalen Haftfestigkeiten, da diese Träger völlig unpolar sind und keine elektronische Wechselwirkung mit den aufgebrachten Metallschichten zeigen.

Es war daher Aufgabe der vorliegenden Erfindung, ein Verfahren zur Vorbehandlung karbidischer und nitridischer keramischer Körper, insbesondere von Siliziumkarbid, Siliziumnitrid und Aluminiumnitrid zu entwickeln, deren Oberflächen anschließend mittels physikalischer Methoden metallisiert werden, mit der ein Optimum an Haftfestigkeit der Metallschichten auf den keramischen Oberflächen erzielt werden kann.

Diese Aufgabe wird erfindungsgemäß dadurch gelöst, daß die Oberflächen einer hochenergetischer Ionenstrahlung mit Energien $\geq$ 10 keV und Dosen von $10^{16}$ bis $10^{18}$ Teilchen/cm² ausgesetzt werden.

Vorzugsweise verwendet man Ionenstrahlen mit Energien $\geq$ 100 keV. Als Ionen haben sich beispielsweise Stickstoff, Silizium und Nickel sehr geeignet erwiesen.

Nach dem Bestrahlen mit hochenergetischen Ionen lassen sich auf Formkörper aus beispielsweise Siliziumkarbid und Aluminiumnitrid festhaftende Schichten aus beispielsweise Germanium, Gold oder Nickel durch Aufdampfen aufbringen.

Die metallographischen Untersuchungen zeigen, daß die aufgedampften Metallschichten über die implantierten Ionen im Grundkörper fest verankert sind.

Folgendes Beispiel soll das erfindungsgemäße Verfahren näher erläutern:

Eine Platte aus Aluminiumnitrid (20 $\times$ 20 $\times$ 2 mm³) wurde in einer Beschleunigungsanlage mit Nickelionen von rund 120 keV beschossen mit einer Dosis von $4 \cdot 10^{17}$ Teilchen/cm². Die Nickelionen erreichten eine Eindringtiefe von ca. 0,1 um und änderten die Struktur der Oberflächenschicht des Plättchens derart, daß eine nahezu amorphe Struktur entstand. Anschließend wurde in einer Aufdampfanlage eine 2 um starke Nickelschicht aufgedampft. Es ergab sich eine hervorragende Haftung der Nickelschicht auf dem Aluminiumnitrid-Träger.

## Ansprüche

1. Verfahren zur Vorbehandlung karbidischer und nitridischer keramischer Körper, insbesondere von Siliziumkarbid, Siliziumnitrid und Aluminiumnitrid, deren Oberflächen anschließend mittels physikalischer Methoden metallisiert werden.
dadurch gekennzeichnet,
daß die Oberflächen einer hochenergetischen Ionenstrahlung mit Energien $\geq$ 10 keV und Dosen von $10^{16}$ bis $10^{18}$ Teilchen/cm² ausgesetzt werden.

2. Verfahren nach Anspruch 1,
dadurch gekennzeichnet,
daß eine Ionenstrahlung mit Energien $\geq$ 100 keV verwendet wird.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl 4) |
|---|---|---|---|
| Y | FR-A-2 449 663 (DEGUSA) * Ansprüche 1,4,5; Seite 3, Zeilen 11-14 * | 1,2 | C 04 B 41/80<br>C 04 B 41/88<br>C 23 C 14/02 |
| | --- | | |
| P,Y | CHEMICAL ABSTRACTS, Band 104, Nr. 24, Juni 1986, Seite 286, Zusammenfassung Nr. 211935n, Columbus, Ohio, US; & JP-A-60 239 378 (TOYOTA CENTRAL RESEARCH AND DEVELOPMENT LABORATORIES, INC.) 28-11-1985 | 1,2 | |
| | --- | | |
| A | EP-A-0 152 951 (KABUSHIKI KAISHA TOYOTA CHUO KENKYUSHO) | | |
| | --- | | |
| A | PATENT ABSTRACTS OF JAPAN, Band 6, Nr. 78 (C-102)[956], 15. Mai 1982; & JP-A-57 13 173 (MEIDENSHA K.K.) 23-01-1982 | | |
| | ----- | | |

RECHERCHIERTE SACHGEBIETE (Int. Cl.4)

C 04 B 41/00
C 23 C 14/00

Der vorliegende Recherchenbericht wurde für alle Patentansprüche erstellt.

| Recherchenort | Abschlußdatum der Recherche | Prüfer |
|---|---|---|
| DEN HAAG | 18-08-1987 | DAELEMAN P.C.A. |